# EUROPÄISCHE PATENTSCHRIFT

(11) **EP 0 445 174 B1**
(45) Veröffentlichungstag und Bekanntmachung des Hinweises auf die Patenterteilung: **17.03.1993**
(21) Anmeldenummer: 89913067.8
(22) Anmeldetag: 28.11.1989
(51) Int. Cl.: B23K 1/00, C23G 5/02

(54) **VERFAHREN UND VORRICHTUNG ZUM REINIGEN VON GEGENSTÄNDEN**
PROCESS AND DEVICE FOR CLEANING OBJECTS
PROCEDE ET DISPOSITIF DE NETTOYAGE D'OBJETS

(30) Priorität: 28.11.1988 DE 3840098
(43) Veröffentlichungstag der Anmeldung: 11.09.1991
(73) Patentinhaber: LEICHT, Helmut, Walter, D-86343 Königsbrunn (DE)
(72) Erfinder: LEICHT, Helmut, Walter, D-86343 Königsbrunn (DE)
(74) Vertreter: VOSSIUS & PARTNER
(86) Internationale Anmeldenummer: EP8901442
(87) Internationale Veröffentlichungsnummer: WO9006203

(56) Entgegenhaltungen:
- DE-A- 3 006 045
- DE-A- 3 028 325
- DE-A- 3 422 562
- FR-A- 2 418 034
- GB-A- 2 159 084
- US-A- 3 298 588
- US-A- 3 435 801
- US-A- 3 724 418
- US-A- 4 315 042
- US-A- 4 809 443

## Beschreibung

Die Erfindung betrifft ein Verfahren und eine Vorrichtung zum Entfernen von Lötmittelrückständen bei Gegenständen, insbesondere bei bestückten Leiterplatten oder Baugruppen, nach dem Dampfphasenlöten.

Obwohl nachstehend die Erfindung weitgehend als Nachbehandlung im Zusammenhang mit dem Dampfphasen-Löten von elektronischen Bauelementen auf Leiterplatten beschrieben wird, ist hierauf die Erfindung jedoch nicht beschränkt. Obwohl das Dampfphasen-Löten das bevorzuge Anwendungsgebiet ist, besteht darüber hinaus die Möglichkeit, die erfindungsgemäßen Reinigungsmaßnahmen auch allgemein bei anders vorbehandelten, gelöteten Gegenständen anzuwenden.

Aus der US-A-3,724,418 ist eine Lötanlage bekannt, bei der wasserlösliche Lötmittelrückstände mittels aufgesprühtem heißen Wasser von den gelöteten Baugruppen entfernt werden kann.
Aus der DE-A-30 06 045 ist ein Verfahren zum Reinigen von flachen Gegenständen, wie Leiterlatten und Flachbaugruppen, bekannt, bei dem die Gegenstände vorzugsweise aufrecht kontinuierlich in horizontaler Richtung durch eine Rammer geführt werden, wobei die Reinigungsflüssigkeit aus den beidseitig angeordneten Spritzdüsen gleichzeitig von beiden Seiten auf die Oberfläche der zu reinigenden Gegenstände gesprüht wird. Die Flüssigkeitsstrahlen haben dabei die Aufgabe, sowohl die flachen Gegenstände auf dem Transportweg zu führen, als auch die Reinigung durch Auflösen und Abspülen der Verunreinigungen zu bewirken. Die verwendete Reinigungsflüssigkeit löst dabei die Verunreinigungen auf.

Aus der DE-A-30 28 325 ist ein Verfahren zum Reinigen von gedruckten Schaltungsplatinen bekannt, bei dem ebenfalls die zu entfernenden Substanzen, wie Flußmittel, durch Besprühen mit Hilfe einer Reinigungsflüssigkeit entfernt werden sollen. Um auch Verunreinigungen aus relativ unzugänglichen Bereichen zu entfernen, beschreibt die DE-A-30 28 325 verschiedene Maßnahmen, wie Richtung, Druck und Geschwindigkeit der Reinigungsflüssigkeitsstrahlen.

Aus der DE-A-34 22 562 ist ein weiteres Verfahren zum Reinigen von Schaltungsplatinen nach dem Löten bekannt. Dabei werden die Verunreinigungen zunächst durch Waschen und Bürsten unter Verwendung eines flüssigen Lösungsmittels entfernt; danach werden die so gereinigten Schaltungsplatinen getrocknet. Das eingesetzte Lösungsmittel wird in einer Destillationseinrichtung gereinigt und dann in einem geschlossenen Kreislauf erneut als Lösungsmittel eingesetzt.

Den verschiedenen vorbekannten Verfahren ist gemeinsam, daß die Reinigungsflüssigkeit die zu entfernenden Verunreinigungen, wie Flußmittel, auflöst, so daß die aus der Reinigungsstufe austretende Reinigungsflüssigkeit mit den Verunreinigungen belastet ist. Es ist also erforderlich, bei gewünschter Wiederverwendung die eingesetzte Reinigungsflüssigkeit nach der Reinigungsbehandlung einer eigenen Reinigung zu unterziehen, um sie für die eigentliche Reinigung der Schaltungsplatinen wieder einsetzen zu können. Darüber hinaus bestehen, wie sich auch aus den vorstehenden Druckschriften ergibt, erhebliche Probleme bei der Reinigung von Schaltungsplatinen mit derartigen Waschflüssigkeiten insbesondere bei hoher Packungsdichte der Bauelemente auf den Schaltungsplatinen. Dieses Problem wird in jüngster Zeit weiter dadurch verschärft, da die zunehmend eingesetzten oberflächenmontierten Bauelemente (SMD = surface mounted device) sehr dicht auf der Schaltungsplatine aufliegen und die Anschlüsse in vielen Fällen direkt unterhalb des eigentlichen Bauelements mit der Schaltungsplatine verlötet sind. Wegen dieser beengten Verhältnisse ist es außerordentlich schwierig, wenn nicht unmöglich, die üblicherweise eingesetzte Reinigungsflüssigkeit in ausreichender Menge zum Auflösen der Verunreinigungen bis an die Lötstellen zu bringen und auch wieder in möglichst kurzer Zeit abzuführen. Zur Lösung dieses Problems werden daher bislang sehr stark wirkende und damit aggressive Reinigungsflüssigkeiten eingesetzt, die wiederum die Bauelemente und die Schaltungsplatinen in nicht akzeptabler Weise angreifen. Die bei bekannten Reinigungsanlagen eingesetzten Fluorchlorkohlenwasserstoffe (FCKW) entweichen während des Betriebs und belasten die Umwelt.

Ein weiteres Problem würde sich beim Betrieb der bekannten Reinigungsanlagen unmittelbar im Anschluß an Dampfphasen-Lötanlagen ergeben; werden nämlich diese beiden Anlagen aneinander anschließend im Durchlaufverfahren betrieben, so werden beim Einschleusen der Baugruppen in die Reinigungsanlage gleichzeitig eine gewisse Menge des Wärmeübertragungsmediums aus der Dampfphasen-Lötanlage eingeschleppt und in der Reinigungsanlage mit der Reinigungsflüssigkeit vermischt. Diese zusätzliche Verunreinigung der Reinigungsflüssigkeit würde zusätzliche Reinigungsmaßnahmen erfordern. Darüber hinaus wären die Ausschleppverluste des relativ teueren Wärmeübertragungsmediums aus der Dampfphasen-Lötanlage erheblich.

Aus der DE-A-35 18 405 ist es bekannt, beim Dampfphasenlöten nach dem Auftragen des Lötmittels eventuell überschüssiges noch flüssiges Lötmittel durch Besprühen mit dem Dampfphasenmedium in flüssiger Form zu entfernen oder einzuebnen.

Wegen des noch flüssigen Lötmittels besteht die Gefahr, daß durch das Besprühen die Bauelemente verrutschen. Mit dem Entfernen von Lötmittelrückständen, also nach dem Verfestigen des Lötmittels befaßt sich diese Druckschrift nicht.

Demgegenüber liegt der Erfindung die Aufgabe zugrunde, ein Verfahren und eine Vorrichtung zum Entfernen von Lötmittelrückständen bei Gegenständen, insbesondere bei bestückten und gelöteten Leiterplatten oder Baugruppen, nach dem Lötprozeß anzugeben, wobei auf die Verwendung von Lösungsmitteln weitgehend verzichtet werden kann.

Diese Aufgabe wird mit den Merkmalen der Patentansprüche gelöst.

Die erfindungsgemäße Lösung geht von dem Grundgedanken aus, bei der Reinigung auf den Einsatz eines Lösungsmittels möglichst zu verzichten und statt dessen eine erwärmte Reinigungsflüssigkeit einzusetzen, deren Temperatur in der Reinigungsstufe unterhalb des Schmelzpunktes der nicht zu entfernenden Materialien, z.B. des Lotes gehalten wird; vorzugsweise liegt die Temperatur der Reinigungsflüssigkeit in der Reinigungsstufe nur geringfügig unterhalb des Schmelzpunktes des zu entfernenden Materials. Die zu beseitigenden Verunreinigen, wie das Flußmittel, werden also nicht in üblicher Weise in einem Lösungsmittel aufgelöst sondern durch die erwärmte Reinigungsflüssigkeit verflüssigt bzw. flüssig gehalten und durch die Reinigungsflüssigkeit weggespült. Der Schmelzpunkt von üblicherweise eingesetztem Lot liegt bei 183°C, so daß die Temperatur der Reinigungsflüssigkeit im Bereich von 150°C bis 180°C gehalten wird; als besonders vorteilhaft hat sich eine Temperatur von etwa 175°C erwiesen.

Entscheidend für die Wahl der Temperatur der Reinigungsflüssigkeit in der Reinigungsstufe ist es, daß sie einerseits so niedrig liegt, daß das nicht zu entfernende Material nicht aufgeschmolzen wird, und andererseits so hoch liegt, daß das zu entfernende Material verflüssigt bzw. flüssig gehalten wird.

Das erfindungsgemäße Verfahren kann in besonders vorteilhafter Weise direkt im Anschluß an den Lötvorgang erfolgen, d.h., wenn die Lötstellen noch erwärmt sind. Besondere Vorteile ergeben sich insbesondere dann, wenn das Löten in einer Dampfphasen-Lötanlage erfolgt, etwa wie in der DE-Patentanmeldung P 38 14 870.6 des gleichen Anmelders. In diesem Fall können die in der Dampfphasen-Lötanlage bei z.B. 215°C behandelten Schaltungsplatinen zunächst in einer Temperiereinrichtung auf eine definierte Temperatur (z.B. 175°C) unterhalb des Schmelzpunktes des Lotes (z.B. 183°C) gesteuert abgekühlt werden, bevor sie in der eigentlichen Reinigungsstufe mit der erwärmten Reinigungsflüssigkeit besprüht werden. In diesem Fall ist es besonders vorteilhaft, als Reinigungsflüssigkeit die gleiche Flüssigkeit einzusetzen wie für das Wärmeübertragungsmedium in der Dampfphasen-Lötanlage , da dann eine wechselseitige Verunreinigung von Wärmeübertragungsmedium und Reinigungsflüssigkeit ausgeschlossen ist. Eine vorteilhafte Ausgestaltung dieser Kombination von Dampfphasen-Lötanlage und Reinigungsstufe besteht demnach in dem Einsatz lediglich eines einzigen Behandlungsmediums, das in der Dampfphasen-Lötanlage in Dampfform vorliegt, während es in der Reinigungsstufe unterhalb seines Siedepunktes und unterhalb des Schmelzpunktes des Lotes versprüht wird.

Weitere vorteilhafte Ausgestaltungen ergeben sich aus den Unteransprüchen sowie aus der nachstehenden Figurenbeschreibung.

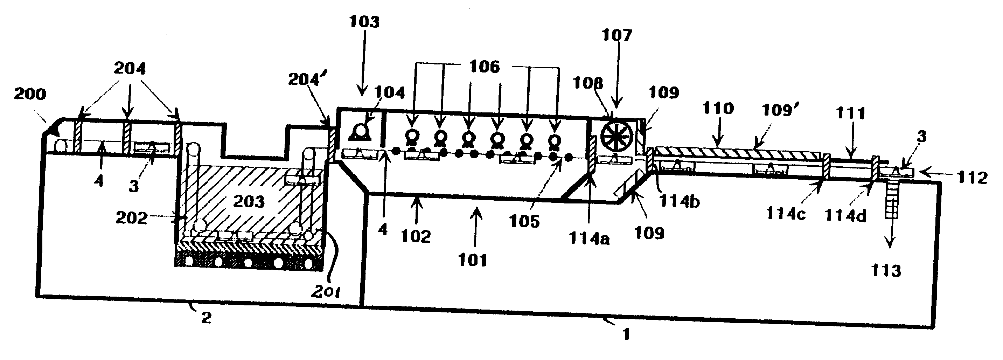

Die Figur zeigt eine schematische Darstellung einer erfindungsgemäßen Kombination aus Dampfphasen-Lötanlage und erfindungsgemäßer Reinigungsanlage.

Die dargestellte Gesamtanlage aus Dampfphasen-Lötanlage 2 und Reinigungsanlage 1 ist als Durchlaufanlage ausgeführt, d.h. die zu behandelnden Gegenstände werden auf einer durchgehenden Transportstrecke 4 mittels Werkstückträgern 3 von einer Beschickungsstation 200 der Dampfphasen-Lötanlage zunächst diese und dann die Reinigungsanlage 1 durchlaufend, bis zu einer Ausgabestation 112 transportiert. Eine mögliche Dampfphasen-Lötanlage 2 ist ausführlich in der DE-Patentanmeldung P 38 14 870.6 des gleichen Anmelders beschrieben. Die in der Beschickungsstation 200 auf Werkstückträger 3 aufgegebenen, zu behandelnden Gegenstände werden über Schleusenanordnungen 204 mit Hilfe einer Transporteinrichtung 202 durch den Behandlungsraum 201 der Dampfphasen-Lötanlage 2 transportiert. Die Dampfphasen-Lötbehandlung erfolgt innerhalb des Behandlungsraums 201 in einem Dampfphasen-Bereich 203, der mit Hilfe des Wärmeübertragungsmediums z.B. auf einer Temperatur von 215°C gehalten wird. Die so behandelten (gelöteten) Gegenstände, wie Leiterplatten, verlassen schließlich die Dampfphasen-Lötanlage 2 über eine Schleusenanordnung 204′ und treten unmittelbar danach (von links her in der Zeichnung) in die direkt angeschlossene Reinigungsanlage 1 ein. Diese Schleusenanordnung 204′ kann durch einen Flüssigkeitsvorhang gebildet werden, wobei als Flüssigkeit vorzugsweise die gleiche Flüssigkeit wie für die Reinigung und gegebenenfalls für die Wärmeübertragung verwendet wird. Zumindest sollte die "Schleusenflüssigkeit" mit den beiden zuletzt genannten Flüssigkeiten verträglich sein. Kernstück dieser Reinigungsanlage 1 ist die Reinigungsstation 101 mit dem zugehörigen Kammergehäuse 102. In dieser Reinigungsstation 101 werden die gelöteten Baugruppen mit der inerten Reinigungsflüssigkeit besprüht, deren Temperatur so eingestellt ist, daß sie geringfügig unterhalb der Schmelztemperatur des Lotes liegt. Bei dieser Temperatur, z.B. 175°C, werden die auf der Leiterplatte bzw. den Lötstellen befindlichen Verunreinigungen, wie Flußmittelbestandteile, verflüssigt bzw. flüssig gehalten und von der Leiterplatte gewaschen. Zur Ausbildung der Sprühstrahlen der Reinigungsflüssigkeit sind Feinstrahldüsen 106 vorgesehen, die die Leiterplatten unter verschiedenen Winkeln besprühen; um eine möglichst optimale Reinigung zu erhalten, sollten einige Düsen senkrecht auf die Leiterplatten gerichtger sein, während andere Düsen unter verschiedenen Winkeln bis praktisch horizontal die Reinigungsflüssigkeit abgeben. Dadurch und durch Ausbildung sehr feiner Strahlen wird erreicht, daß die Reinigungsflüssigkeit auch bis in schwer zugängliche Bereiche etwa unterhalb von SMD-Bauelementen vordringt und die dort vorhandenen Verunreinigungen bei erhöhter Temperatur abwäscht.

Wie in der Zeichnung dargestellt, kann vor die eigentliche Reinigungsstation 101 und unmittelbar im Anschluß an die Lötanlage 2 eine Temperiereinrichtung 103 zwischengeschaltet werden, um die aus der Lötanlage 2 austretenden Baugruppen zunächst möglichst rasch und wohl definiert auf eine bestimmte Temperatur unterhalb des Schmelzpunktes des Lotes, z.B. bis auf 175°C abzukühlen. Zu diesem Zweck kann in der Temperiereinrichtung 103 eine Düsenanordnung 104 vorgesehen werden, mit der die Baugruppen mit einer erwärmten Flüssigkeit oder einem erwärmten Gas besprüht werden; die Temperatur des zu versprühenden Mediums sollte dabei vorzugsweise gleich der der Reinigungsflüssigkeit in der Reinigungsstufe 101 sein, also z.B. 175°C betragen. Das Aufsprühen des von der Düsenanordnung 104 abgegebenen Mediums erfolgt bei relativ geringem Druck, um eine Verschiebung der Bauelemente auf der Schaltungsplatine zu vermeiden, da bei Eintritt der gelöteten Schaltungsplatinen in die Temperiereinrichtung 103 die Temperatur der Lötstellen noch oberhalb der Schmelztemperatur des Lotes liegen kann. Mit der Temperiereinrichtung 103 wird daher eine schonende und rasche Abkühlung der gelöteten Schaltungsplatinen auf eine Temperatur unterhalb des Schmelzpunktes des Lotes gewährleistet. Dadurch ist die Fixierung der Bauelemente auf der Leiterplatte sichergestellt, so daß in der nachfolgenden Reinigungsstufe 101 ein unbeabsichtigtes Ablösen der Bauelemente durch die unter relativ hohem Druck von den Düsen 106 abgegebene Reinigungsflüssigkeit nicht eintreten kann.

Vorzugsweise wird zum Versprühen in der Temperiereinrichtung 103 die gleiche Flüssigkeit eingesetzt wie in der Reinigungsstufe 101, so daß keinerlei Probleme aufgrund unerwünschter Vermischung der Medien auftreten können. Da, wie vorstehend bereits erläutert, als Reinigungsflüssigkeit vorzugsweise die gleiche Substanz wie für das Wärmeübertragungsmedium in der Dampfphasen-Lötanlage 2 verwendet wird, erhält man damit eine durchgehende Behandlungsstrecke von der Dampfphasen-Lötanlage 2 über die Temperiereinrichtung 103 und die Reinigungsstufe 101 mit gleichbleibender Atmosphäre, so daß Vermischungsprobleme von vornherein ausgeschlossen sind.

Der Transport der Werkstücke durch die Reinigungsstufe 101 und gegebenenfalls die Temperiereinrichtung 103 erfolgt mit Hilfe einer Transporteinrichtung 105 vorzugsweise auf einer horizontalen Transportstrecke 4.

Vorzugsweise werden die Werkstücke während des Durchlaufs durch die Reinigungsstufe 101 und gegebenenfalls auch im Bereich der Temperiereinrichtung 103 und der Trocknungsstufe 107 hin- und hergekippt, um das Abfließen der Reinigungsflüssigkeit sowie des abzuwaschenden Flußmittels zu erleichtern. Da sich dabei in der Reinigungsstufe 101 gleichzeitig auch die Sprührichtung zwischen den Düsen 106 und den Werkstücken verändert, wird auch die Reinigungswirkung weiter verbessert.

Die Reinigungsstufe 101 ist ausgangsseitig mit einem Schleusentor 114a versehen, um den Austritt von Reinigungsflüssigkeit auf ein Minimum während des Ausschleusens der Leiterplatten zu begrenzen.

An die Reinigungsstufe 101 sollten sich zweckmäßig eine Trocknungsstufe 107, eine Kühlstufe 110 und/oder eine Pufferstrecke 111 anschließen, damit die durchlaufenden Werkstücke abgekühlt an der Ausgabestation 112 abgegeben werden können. Innerhalb der Trocknungsstufe 107 kann mit Hilfe eines Umluftgebläses 108 der Trocknungsprozeß beschleunigt werden. Ferner können sowohl in der Trocknungsstufe 107 als auch in der Kühlstufe 110 Kühleinrichtungen 109 bzw. 109′ vorgesehen sein, um das verdunstende Medium zu kondensieren In der in Transportrichtung der Werkstücke der Trocknungsstufe 107 nachgeschalteten Kühlstufe 110 werden die Werkstücke abgekühlt, so daß sie über eine Pufferstrecke 111 zu der Ausgabestation 112 ausgeschleust werden können. Durch diese kontrollierte Abkühlung in dem abgeschlossenen Raum der Kühlstufe 110, die weitgehend frei von Umgebungsluft ist, wird aufgrund der erniedrigten Lötstellentemperatur eine unerwünschte Oxidation der Lötstellen weitgehend verhindert. Ferner wird durch die Schleusenanordnung mit Schleusentoren 114a bis d das Ausschleppen von Reinigungsflüssigkeit weitgehend vermieden. Die in den verschiedenen Behandlungsstufen (Temperiereinrichtung 103, Reinigungsstufe 101, Trocknungsstufe 107, Kühlstufe 110 und Pufferstrecke 111) anfallende Reinigungsflüssigkeit wird über ein nicht dargestelltes Rückführsystem dem Reinigungsprozess erneut zugeführt.

An der Ausgabestation 112 kann eine Absaugeinrichtung 113 vorgesehen werden, um eventuell austretende Dampfreste abzusaugen, auszukondensieren und über das genannte Rückführsystem dem Reinigungsprozess wieder zuzuführen.

Wie vorstehend dargelegt, sind die verschiedenen Behandlungsstufen durch Schleusen voneinander getrennt, die sich gegebenenfalls automatisch gesteuert, nur bei Bedarf öffnen, um das Ausschleppen der relativ teueren und gegebenenfalls umweltschädlichen Behandlungsmedien weitgehend zu verhindern.

Da in der erfindungsgemäßen Anlage keine Säuren zum-Entfernen von Lötrückständen eingesetzt werden müssen, kann anstelle von Edelstahlblech preiswertes Aluminiumblech zum Aufbau des Gehäuses eingesetzt werden, wobei die Aluminiumbleche miteinander verschraubt werden können. Dies erlaubt eine kostengünstige flexible Herstellung der Gesamtanlage.

Beim Betrieb einer Dampfphasen-Lötanlage tritt ferner das Problem auf, daß die Werkstücke beim Eintritt in den Behandlungsraum 201 sehr rasch aufgeheizt werden und dabei beschädigt werden können, da der Wärmeübergang bei der Kondensation des Wärmeübertragungsmediums sehr hoch ist. Erfindungsgemäß wird daher vorgeschlagen, die Werkstücke vor dem Einfahren in den Behandlungsraum 201, 203 gesteuert aufzuheizen, z.B. stufenweise zunächst auf 80°C und dann auf 120°C, etwa mittels einer Düsen- und Vernebelungsanordnung ähnlich der (allerdings umgekehrt als Kühlstufe wirkenden) Temperiereinrichtung 103 der Reinigungsvorrichtung 1. Dabei ist festzuhalten, daß diese gesteuerte Aufheizung vor dem Dampfphasenlöten sowohl mit als auch ohne das beschriebene Reinigungsverfahren erfindungsgemäß durchgeführt werden kann.

## Patentansprüche

1. Verfahren zum Dampfphasenlöten und zum Entfernen von Lötrückständen bei Gegenständen nach dem Lötprozeß, insbesondere bei bestückten Leiterplatten oder Baugruppen, dadurch gekennzeichnet, daß das Entfernen der Lötrückstände durch Abwaschen mittels einer inerten Reinigungsflüssigkeit erfolgt, die auf einer Temperatur unterhalb, vorzugsweise geringfügig unterhalb des Schmelzpunktes des Lotes gehalten wird, und daß als Reinigungsflüssigkeit die gleiche Flüssigkeit wie für das Wärmeübertragungsmedium beim Dampfphasenlöten eingesetzt wird.

2. Verfahren nach Anspruch 1, dadurch gekennzeichnet, daß die Temperatur der inerten Reinigungsflüssigkeit bei Abwaschen im Bereich von 150°C bis 180°C, vorzugsweise bei 175°C, gehalten wird.

3. Verfahren nach Anspruch 1 oder 2, dadurch gekennzeichnet, daß die inerte Reinigungsflüssigkeit unter Druck auf die Gegenstände aufgesprüht wird.

4. Verfahren nach einem der Ansprüche 1 bis 3, dadurch gekennzeichnet, daß die inerte Reinigungsflüssigkeit unter verschiedenen Winkeln auf die Gegenstände aufgesprüht wird.

5. Verfahren nach Anspruch 4, dadurch gekennzeichnet, daß der Sprühwinkel von 0° bis 90° gegenüber der Vertikalen bezogen auf die Gegenstände beträgt.

6. Verfahren nach einem der Ansprüche 1 bis 5, dadurch gekennzeichnet, daß nach dem Entfernen der Lötrückstände die Gegenstände getrocknet werden.

7. Verfahren nach Anspruch 6, dadurch gekennzeichnet, daß in der Trocknungsstufe (107) zum Verdunsten und Abscheiden der inerten Reinigungsflüssigkeit die Luft umgewälzt wird.

8. Verfahren nach Anspruch 6 oder 7, dadurch gekennzeichnet, daß die Gegenstände nach dem Trocknen gekühlt werden.

9. Verfahren nach einem der Ansprüche 1 bis 8, dadurch gekennzeichnet, daß vor dem Reinigen die Gegenstände mit einem Nebel aus einer inerten Temperierflüssigkeit bei einer Temperatur unterhalb, vorzugsweise geringfügig unterhalb, des Schmelzpunktes des Lotes behandelt, vorzugsweise besprüht werden.

10. Verfahren nach Anspruch 9, dadurch gekennzeichnet, daß als inerte Temperierflüssigkeit für den Sprühnebel die gleiche Flüssigkeit wie für die Reinigung (inerte Reinigungsflüssigkeit) verwendet wird.

11. Verfahren nach einem der Ansprüche 1 bis 10, dadurch gekennzeichnet, daß das Entfernen der Lötrückstände im Durchlaufverfahren oder im Pendelbetrieb erfolgt.

12. Vorrichtung zum Dampfphasenlöten und zum Entfemen von Lötrückständen bei Gegenstäden nach dem Lötprozeß, gekennzeichnet durch eine Reinigungsstation (101) mit mehreren auf die zu reinigenden Gegenstände gerichteten Düsenanordnungen (106) zum Versprühen des Wärmeübertragungsmediums als inerte Reinigungsflüssigkeit und durch eine Einrichtung zum Einstellen der Temperatur der Reinigungsflüssigkeit auf einen Wert unterhalb, vorzugsweise geringfügig unterhalb des Schmelzpunktes des Lotes.

13. Vorrichtung nach Anspruch 12, gekennzeichnet durch eine der Reinigungsstufe (101) vorgeschaltete Temperiereinrichtung (103).

14. Vorrichtung nach Anspruch 12 oder 13, gekennzeichnet durch eine der Reinigungsstufe (101) nachgeschaltete Trocknungsstufe (107).

15. Vorrichtung nach Anspruch 14, dadurch gekennzeichnet, daß die Trocknungsstufe ein Umwälzgebläse (108) aufweist.

16. Vorrichtung nach Anspruch 14 oder 15, dadurch gekennzeichnet, daß die Trocknungsstufe (107) mindestens eine Kühleinrichtung (109) zum bescheiden der inerten Reinigungsflüssigkeit aufweist.

17. Vorrichtung nach einem der Ansprüche 12 bis 16, dadurch gekennzeichnet, daß der Reinigungsstufe (101) bzw, der Trocknungsstufe (107) eine Kühlstufe (110) nachgeschaltet ist.

18. Vorrichtung nach Anspruch 17, dadurch gekennzeichnet, daß die Kühlstufe (110) einen Wärmetauscher (109′) aufweist.

19. Vorrichtung nach einem der Ansprüche 12 bis 18, dadurch gekennzeichnet, daß vor der Ausgabestation (112) eine Pufferstrecke (111) vorgesehen ist.

20. Vorrichtung nach einem der Ansprüche 12 bis 19, dadurch gekennzeichnet, daß die Ausgabestation (112) eine Absaugeinrichtung (113) aufweist.

21. Vorrichtung nach einem der Ansprüche 12 bis 20, dadurch gekennzeichnet, daß sie als Durchlaufanlage oder Pendelanlage ausgebildet ist.

22. Vorrichtung nach einem der Ansprüche 12 bis 21, dadurch gekennzeichnet, daß zwischen den verschiedenen Behandlungsstationen sowie eingangs- und, ausgangsseitig Schleusenanordnungen (114, 204), vorzugsweise in Form von mechanischen Toren, vorgesehen sind.

23. Vorrichtung nach Anspruch 2 2, dadurch gekennzeichnet, daß die Schleusenanordnung (204′) zwischen dem Behandlungsraum (201) und der Reinigungsstation (101) durch einen Flüssigkeitsvorhang gebildet wird.

24. Vorrichtung nach Anspruch 23, dadurch gekennzeichnet, daß für den Flüssigkeitsvorhang eine mit der Reinigungsflüssigkeit und mit dem Wärmeübertragungsmedium verträgliche Flüssigkeit, vorzugsweise die gleiche Flüssigkeit wie für die Reinigung und für die Wärmeübertragung, eingesetzt wird.

25. Vorrichtung nach einem der Ansprüche 12 bis 24, dadurch gekennzeichnet, daß das Gehäuse aus miteinander verschraubten Aluminiumblechen aufgebaut ist.

## Claims

1. A process for the vapour phase soldering of and for the removal of solder residue from objects after the soldering process, in particular in the case of printed board assemblies or componentry,
**characterised in that** the removal of the solder residue is performed by washing by means of an inert cleaning fluid, which is kept at a temperature below, preferably slightly below, the melting point of the solder, **and in that** the same fluid is used as the cleaning fluid as for the heat transfer medium in the vapour phase soldering.

2. A process according to Claim 1,
**characterised in that** during washing the temperature of the inert cleaning fluid is kept in the region of 150° to 180°C, preferably at 175°C.

3. A process according to Claim 1 or 2,
**characterised in that** the inert cleaning fluid is sprayed onto the objects under pressure.

4. A process according to one of Claims 1 to 3,
**characterised in that** the inert cleaning fluid is sprayed onto the objects at various angles.

5. A process according to Claim 4,
**characterised in that** the spray angle is from 0° to 90° vis-å-vis the verticals with respect to the objects.

6. A process according to one of Claims 1 to 5,
**characterised in that** after the removal of the solder residue the objects are dried.

7. A process according to Claim 6,
**characterised in that** in the drying stage (107) the air is circulated to evaporate and separate the inert cleaning fluid.

8. A process according to Claim 6 or 7,
**characterised in that** the objects are cooled after drying.

9. A process according to one of Claims 1 to 8,
**characterised in that** before cleaning the objects are treated, preferably sprayed, with a mist of an inert tempering fluid at a temperature below, preferably slightly below, the melting point of the solder.

10. A process according to Claim 9,
**characterised in that** the same fluid is used as the inert tempering fluid for the spray mist as for the cleaning (inert cleaning fluid).

11. A process according to one of Claims 1 to 10,
**characterised in that** the removal of the solder residue is performed in the continuous operation or in the pendulum operation.

12. A device for the vapour phase soldering of and for the removal of solder residue from objects after the soldering process,
**characterised by** a cleaning station (101) having several nozzle arrangements (106) directed at the objects to be cleaned for atomization of the heat transfer medium as inert cleaning fluid, **and by** an appliance for adjusting the temperature of the cleaning fluid to a value below, preferably slightly below, the melting point of the solder.

13. A device according to Claim 12,
**characterised by** a tempering device (103) connected in front of the cleaning stage (101).

14. A device according to Claim 12 or 13,
**characterised by** a drying stage (107) connected after the cleaning stage (101).

15. A device according to Claim 14,
**characterised in that** the drying stage comprises a circulating fan (108).

16. A device according to Claim 14 or 15,
**characterised in that** the drying stage (107) comprises at least one cooling device (109) for the separation of the inert cleaning fluid.

17. A device according to one of Claims 12 to 16,
**characterised in that** a cooling stage (110) is connected after the cleaning stage (101) and the drying stage (107) respectively.

18. A device according to Claim 17,
**characterised in that** the cooling stage (110) comprises a heat exchanger (109′).

19. A device according to one of Claims 12 to 18,
**characterised in that** a buffer section (111) is provided in front of the discharge station (112).

20. A device according to one of Claims 12 to 19, characterised in that the discharge station (112) comprises a suction device (113).

21. A device according to one of Claims 12 to 20,
**characterised in that** it is constructed as a continuous or a reciprocating apparatus.

22. A device according to one of Claims 12 to 21,
**characterised in that** between the various treatment stations sluice arrangements on both the inlet and the outlet side (114, 204) are provided, preferably in the form of mechanical gates.

23. A device according to Claim 22,
**characterised in that** the sluice arrangement (204′) between the treatment chamber (201) and the cleaning station (101) is formed by a curtain of fluid.

24. A device according to Claim 23,
**characterised in that** for the curtain of fluid is used a fluid compatible with the cleaning fluid and with the heat transfer medium, preferably the same fluid as for cleaning and heat transfer.

25. A device according to one of Claims 12 to 24,
**characterised in that** the housing is constructed of aluminium plates screwed together.

## Revendications

1. Procédé pour le brasage en phase vapeur et pour l'élimination des résidus de brasage sur des objets après l'opération de brasage, notamment dans le cas de cartes de circuits imprimés équipées ou de blocs modulaires, caractérisé en ce que l'élimination des résidus de brasage s'effectue par lavage au moyen d'un liquide nettoyant inerte qui est maintenu à une température inférieure, de préférence légèrement inférieure au point de fusion du brasage et en ce que l'on met en oeuvre en tant que liquide nettoyant le même liquide servant d'agent de transfert thermique dans le brasage en phase vapeur.

2. Procédé selon la revendication 1, caractérisé en ce que la température du liquide nettoyant inerte lors du lavage est maintenue dans la plage de 150°C jusqu'à 180°C, de préférence à 175°C.

3. Procédé selon la revendication 1 ou 2, caractérisé en ce que le liquide nettoyant inerte est pulvérisé ou atomisé sous pression sur les objets.

4. Procédé selon l'une des revendications 1 à 3, caractérisé en ce que le liquide nettoyant inerte est pulvérisé ou atomisé sous différents angles sur les objets.

5. Procédé selon la revendication 4, caractérisé en ce que l'angle de pulvérisation sur les objets est de 0 à 90° par rapport à une verticale partant des objets.

6. Procédé selon l'une des revendications 1 à 5, caractérisé en ce qu'après l'élimination des résidus de brasage, on procède au séchage des objets.

7. Procédé selon la revendication 6, caractérisé en ce qu'au cours de l'étape de séchage (107) pour l'évaporation et la séparation du liquide nettoyant inerte, on a recours à de l'air en circulation ou pulsé.

8. Procédé selon la revendication 6 ou 7, caractérisé en ce que les objets sont refroidis après le séchage.

9. Procédé selon l'une des revendications 1 à 8, caractérisé en ce qu'avant le nettoyage, les objets sont traités, de préférence pulvérisés au moyen d'un nébulat constitué par un liquide d'équilibrage de température inerte à une température inférieure, de préférence légèrement inférieure au point de fusion du brasage.

10. Procédé selon la revendication 9, caractérisé en ce qu'en tant que liquide d'équilibrage de température inerte pour le nébulat de pulvérisation, on utilise le même liquide que pour le nettoyage (liquide nettoyant inerte).

11. Procédé selon l'une des revendications 1 à 10, caractérisé en ce que l'élimination des résidus de brasage s'effectue de façon continue ou alternée.

12. Dispositif pour le brasage en phase vapeur et pour l'élimination des résidus de brasage sur des objets après l'opération de brasage, caractérisé par un poste de nettoyage (101) comportant plusieurs systèmes de buses ou gicleurs (106) dirigés sur les objets à nettoyer pour la pulvérisation ou atomisation de l'agent de transfert thermique en tant que fluide nettoyant inerte et par un système pour le réglage de la température du liquide nettoyant à une valeur inférieure, de préférence légèrement inférieure au point de fusion du brasage.

13. Dispositif selon la revendication 12, caractérisé par un système d'équilibrage de température (103) placé en amont de l'étape de nettoyage (101).

14. Dispositif selon la revendication 12 ou la revendication 13, caractérisé par une étape de séchage (107) placée en aval de l'étape de nettoyage (101).

15. Dispositif selon la revendication 14, caractérisé en ce que l'étape de séchage comporte une soufflante de circulation d'air (108).

16. Dispositif selon la revendication 14 ou la revendication 15, caractérisé en ce que l'étape de séchage (107) comporte au moins un système de refroidissement (109) destiné à séparer le liquide nettoyant inerte.

17. Dispositif selon l'une des revendications 12 à 16, caractérisé en ce qu'une étape de refroidissement (110) est située en aval de l'étape de nettoyage (101) ou de l'étape de séchage (107).

18. Dispositif selon la revendication 17, caractérisé en ce que l'étape de refroidissement (110) comporte un échangeur de chaleur (109′).

19. Dispositif selon l'une des revendications 12 à 18, caractérisé en ce qu'une ligne tampon (111) est prévue en amont du poste d'évacuation de déchargement (112).

20. Dispositif selon l'une des revendications 12 à 19, caractérisé en ce que le poste de déchargement ou d'évacuation (112) comporte un système d'aspiration (113).

21. Dispositif selon l'une des revendications 12 à 20, caractérisé en ce qu'il est congru sous forme d'installation continue ou d'installation alternée.

22. Dispositif selon l'une des revendications 12 à 21, caractérisé en ce qu'entre les différents postes de traitement ainsi que sur les côtés entrée et sortie, sont prévus des systèmes de sas (114, 204), de préférence sous forme de portes mécaniques.

23. Dispositif selon la revendication 22, caractérisé en ce que le système de sas (204′) entre la zone de traitement (201) et le poste de nettoyage (101) est constitué par un rideau liquide.

24. Dispositif selon la revendication 23, caractérisé en ce que pour le rideau liquide, on met en oeuvre un fluide compatible avec le liquide nettoyant et avec l'agent de transfert thermique, de préférence le même liquide qui sert pour le nettoyage et le transfert thermique.

25. Dispositif selon l'une des revendications 12 à 24, caractérisé en ce que le logement est constitué par des tôles en aluminium assemblées entre elles par vissage ou boulonnage.
